# EUROPEAN PATENT APPLICATION

(11) **EP 3 217 078 A1**
(43) Date of publication of application: **13.09.2017**
(21) Application number: 16158980.9
(22) Date of filing: 07.03.2016
(51) Int. Cl.: F21V 7/00, G09F 9/302, G09F 23/00, H05K 1/02, F21Y 109/00

(54) **LUMINAIRE, LIGHTING SYSTEM AND PANELED CEILING ARRANGEMENT**

(71) Applicant: Philips Lighting Holding B.V., 5656 AE Eindhoven (NL)
(72) Inventor: The designation of the inventor has not yet been filed
(74) Representative: Verweij, Petronella Daniëlle

(57) **Abstract**

Disclosed is a luminaire (100) comprising a light-transmissive carrier (101) comprising a light exit surface (102); a reflector arrangement (103) opposite the light-transmissive carrier for redirecting light towards the light exit surface; and a pattern (104) of spatially separated solid state lighting devices (105) directly mounted on or in the light-transmissive carrier, each of the solid state lighting devices comprising a light-emissive surface (106) facing the reflector arrangement. A lighting system comprising at least one said luminaire and a controller; and a paneled ceiling arrangement comprising at least one said luminaire or the lighting system are also disclosed.

## Description

### FIELD OF THE INVENTION

This invention relates to a luminaire comprising solid state lighting devices arranged to indirectly illuminate a light exit surface. The invention further relates to a lighting system comprising at least one said luminaire and a controller; and a paneled ceiling arrangement comprising at least one said luminaire or the lighting system.

### BACKGROUND OF THE INVENTION

Solid state lighting devices, such as LEDs, are being increasingly employed in luminaries due to the advantages they offer in terms of energy efficiency and longevity. Such devices may also offer further advantages derived from the configurable nature of their luminous output. For example, the dimming level, colour temperature and/or colour point of the luminous output of solid state lighting devices may be adjusted. This has resulted in development of intelligent luminaires in which solid state lighting devices are employed in combination with one or more sensors and/or controllers for configuring the luminous output provided by the solid state lighting devices.

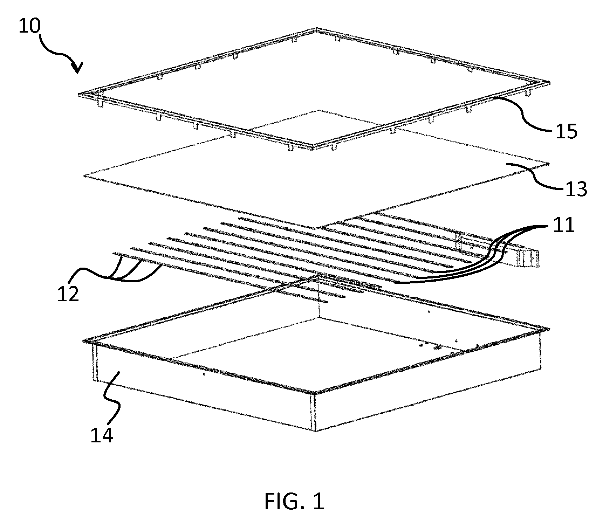

One of the drawbacks of solid state lighting devices is related to the nature of the light profile which they provide. Solid state lighting devices may be considered as approximate point light sources which emit intensely from a small emissive area. Thus if (emitting) solid state lighting devices are viewed directly, significant glare may be experienced by the observer. This issue of glare has necessitated incorporation of particular features into luminaire designs such as panel-luminaire (troffer) designs; an example of such a panel-luminaire design is schematically depicted in FIG. 1.

FIG. 1 shows an exploded perspective view of a prior-art 'up-down' panel-luminaire 10 comprising strips 11 of solid state lighting devices 12, a diffuser 13, mounted in a housing 14 and secured by a rim 15. The solid state lighting devices 12 are mounted such that they emit light directly through the diffuser 13. The diffuser 13 is intended to provide an even illumination emanating from the up-down panel-luminaire 10 and, importantly, serves to reduce glare by partially scattering the intense light emitted by each of the solid state lighting devices 12 before it exits the up-down panel-luminaire 10.

A 'full-window' lighting effect is provided by the up-down panel-luminaire 10 owing to the design serving to obviate opaque fixtures situated beneath the solid state lighting devices 12 which may, if present, partially block light from exiting the luminaire. The up-down design therefore permits the majority of light produced by the solid state lighting devices 12 to exit the up-down panel-luminaire 10.

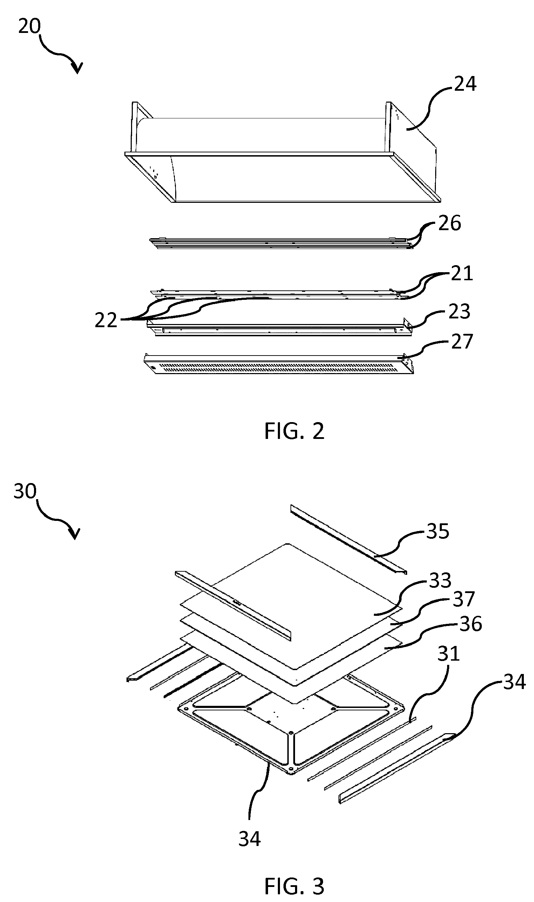

The problem of glare may be alternatively addressed by an 'indirect' panel-luminaire 20, depicted in exploded perspective view in FIG. 2, which also comprises strips 21 of solid state lighting devices 22; the strips being mounted on a carrier 23. The solid state lighting devices 22 are mounted to illuminate a reflective surface 26 which redirects the light (originally) emitted from the solid state lighting devices 22 through a diffuser 27 in order to provide external illumination. The indirect panel-luminaire 20 may be mounted in a housing 24.

The redirection of the light emitted by the solid state lighting devices 22 by the reflective surface 26 further assists in reducing glare since the reflected (redirected) light is more diffuse than that originally emitted by the solid state lighting devices 22. However, the indirect panel-luminaire 20 does not provide a full-window lighting effect: the redirected light from reflective surface 26 is partially blocked from exiting the luminaire 20 by the strips 21 on which the solid state lighting devices 22 are mounted and other features of the design which lie between the reflective surface 26 and the space to be illuminated.

A further prior-art panel-luminaire design which provides both indirect and full-window lighting is depicted in FIG. 3. This side-lit panel-luminaire 30 comprises solid state lighting devices 31 which are disposed at the sides of the panel-luminaire 30 and are mounted to emit light laterally towards a centrally positioned light guide 37 which guides the light emitted by the solid state lighting devices 31 towards diffuser 33; a reflector 36 is positioned behind the light guide 37 to redirect any residual unguided light (which has not been guided towards the diffuser 33) towards the light guide 37. The side-lit panel-luminaire 30 is mounted in a housing 34 and held in place with a rim 35.

As well as having a more complicated and costly design than, for example, the up-down panel-luminaire 10, the side-lit panel-luminaire 30 may also be less compact (i.e. thicker) owing to mounting of the solid state lighting devices 31 in the sides of the panel-luminaire 30.

### SUMMARY OF THE INVENTION

The present invention seeks to provide a luminaire having a simple design that effectively can prevent glare whilst providing substantially uniform illumination.

The invention is defined by the claims.

In accordance with an aspect, there is provided a luminaire comprising:
a light-transmissive carrier comprising a light exit surface;
a reflector arrangement opposite the light-transmissive carrier for redirecting light towards the light exit surface; and
a pattern of spatially separated solid state lighting devices directly mounted on or in the light-transmissive carrier, each of the solid state lighting devices comprising a light-emissive surface facing the reflector arrangement.

A full-window lighting effect may be precluded in conventional indirect luminaire designs because the light sources and the carrier on which the light sources are mounted may partially block redirected/reflected light from exiting the luminaire. The present invention is based on the realization that the very small area occupied by a solid state light device, such as an LED, may be exploited to provide lighting which is simultaneously indirect and substantially full-window by mounting a spatially separated pattern of solid state lighting devices on or in a light-transmissive carrier. By mounting the solid state lighting devices such that their light-emissive surfaces are facing a reflector arrangement, light emitted from the solid state lighting devices is redirected by the reflector arrangement back towards the light-transmissive carrier. Given that the solid state lighting devices are spatially separated, the redirected light may pass through the light-transmissive carrier between the solid state lighting devices and may exit the luminaire via a light exit surface. The small size and spatial separation of the solid state lighting devices ensures that reflected light may exit the luminaire via the light exit surface even in areas of the light exit surface directly beneath the solid state lighting devices such that a substantially full-window lighting effect is attained.

In this way glare is reduced owing to the reflected nature of the light exiting the luminaire but the high luminance yield and full-window lighting effect advantages of an up-down luminaire are retained.

The term 'directly mounted on' may be interpreted to mean that the solid state lighting devices are fixed to the surface of the light-transmissive carrier facing the reflector arrangement without a separate carrier, i.e. the light-transmissive carrier is in direct contact with the solid state lighting devices. The term 'directly mounted in' may be interpreted to mean that the solid state lighting devices are embedded within the light-transmissive carrier.

The luminaire may be a troffer and the light exit surface may be rectangular or circular.

By mounting the solid state lighting devices directly on or in a light-transmissive carrier in a troffer according to the present invention, a more compact (i.e. slimmer) indirectly lit troffer may be achieved which may achieve favourable uniformity of illumination without the requirement for mounting light sources (e.g. solid state lighting devices) in the sides of the luminaire. A slimmer design provides advantages in terms of requiring less construction material and lower cost. Additionally, given that troffers are often recessed into a paneled ceiling arrangement, a slimmer design may be advantageous since the ceiling-facing side of the troffer may extend less intrusively into the plenum space above the paneled ceiling arrangement which may allow greater flexibility in terms of the use of space both below and above the paneled ceiling arrangement.

The light-transmissive carrier may comprise a transmissive material selected from a glass, a transmissive polymer or a transmissive polymer blend, e.g. optical grade polymers comprising polycarbonate, polyethylene terephthalate, poly(methyl methacrylate) and the like.

Such materials may provide the requisite optical transmission properties for the light-transmissive carrier. Such materials may offer suitable rigidity and may also be suitable carriers on or in which to directly mount the pattern of solid state lighting devices, particularly since the thermal properties (e.g. thermal conductivity) of such materials may assist in absorbance of the heat generated by the solid state lighting devices and transfer of this heat to the surroundings.

The light-transmissive carrier may comprise a transmissive electrically conductive structure such as a (patterned) transparent electrically conductive film, wherein the solid state lighting devices are conductively coupled to the transmissive electrically conductive structure.

The solid state lighting devices must be supplied with electrical power in order to emit light. Accordingly, the light-transmissive carrier therefore may comprise a transmissive electrically conductive structure which may conductively couple the solid state lighting devices to the power source and/or to each other. The transmissive electrically conductive structure provides an optically transmissive means of providing such conductive coupling which may assist in provision of the substantially full-window lighting effect of the luminaire since the electrical connections to and/or between the solid state lighting devices may not block light being redirected from the reflector arrangement to the light exit surface. Transparent electrically conductive films, such as indium tin oxide films, carbon nanotube (CNT) films, transparent nanowire-based conductors, metal meshes, conductive polymers etc. may be suitable materials for the transmissive electrically conductive structure since they may be both optically transparent and electrically conductive.

The light-transmissive carrier may comprise a glass printed circuit board, wherein the solid state lighting devices are surface-mounted on the glass printed circuit board.

Surface-mounting the solid state lighting devices on a glass printed circuit board may enhance the transmissive properties of the light-transmissive carrier since the glass printed circuit board may provide the requisite electrical connections between the solid state lighting devices whilst ensuring that redirected light may pass between the surface-mounted solid state lighting devices in order to reach the light exit surface.

The light-transmissive carrier may be at least partially diffusively transmissive.

An at least partially diffusively transmissive light-transmissive carrier may assist in reducing glare by at least partially scattering the redirected light before it exits the light exit surface without requiring a separate diffuser. Furthermore, this may assist in providing even illumination over the light exit surface.

The pattern of spatially separated solid state lighting devices may comprise groups of solid state lighting devices; the reflector arrangement may comprise a plurality of reflective portions, each reflective portion aligning with one of said groups.

By aligning a reflective portion of the reflector arrangement with a group of solid state lighting devices, the light emitted from the light-emissive surfaces of the group of solid state lighting devices may be efficiently redirected by the opposing aligned reflective portion towards the light exit surface.

The pattern may comprise at least one row of solid state lighting devices.

A regular repeating pattern of the solid state lighting devices may assist to ensure an even illumination across the light exit surface. For example, rows may be disposed across the breadth of the light-transmissive carrier with each row of solid state lighting devices extending across the length of the light-transmissive carrier such that even illumination is provided for the complete area of the light exit surface. It will be clear that for such a pattern, it may equivalently be expressed that the rows may be disposed across the length of the light-transmissive carrier with each row extending across the breadth of the light-transmissive carrier. For circular light-transmissive carriers, rows may extend across chords of the circle (such that the rows may be of different length) or the rows may be circular such that the pattern may, for example, comprise a series of concentric rows (circles) of solid state lighting devices. Other regular repeating patterns may be contemplated.

At least two of the solid state lighting devices may be adapted to emit light of different colour with respect to each other.

By employing solid state lighting devices which are adapted to emit light of different colour, the luminaire may provide light with a defined spectral composition via colour mixing, e.g. a colour temperature ranging from about 2,000 to about 8,000 K, e.g. from about 2,500 K to about 6,500 K, and/or a coloured output having a spectral composition having a central spectral component ranging from 400 nm to 700 nm for example.

The at least two of the solid state lighting devices may be individually controllable.

The at least two solid state lighting devices may be, for example, individually dimmable and/or may be able to produce an output having a configurable spectral composition. Thus the luminaire may emit light with a configurable spectral composition by, for example, individual solid state lighting devices being able to produce a configurable spectral composition, or the controllable solid state lighting devices producing outputs of different spectral compositions, wherein a selection of solid state lighting devices may be engaged to produce an output of a desired spectral composition.

The reflector arrangement comprises reflective portions which may be specularly and/or diffusively reflective.

The luminaire may be at least partially encompassed by a housing.

A housing may provide a suitable means for fixing or positioning the light-transmissive carrier and reflector arrangement. This may assist alignment of the reflective portions of the reflector arrangement with the groups of solid state lighting devices directly mounted on or in the light-transmissive carrier. The housing may offer the additional advantage of protecting the components of the luminaire from damage and contamination (e.g. by dust).

The luminaire may comprise a driver circuit configured to regulate power supplied to the solid state lighting devices.

A driver circuit may assist in maintaining a constant output from the solid state lighting devices by regulating the power supplied to the solid state lighting devices. Additionally, the driver circuit may protect the solid state lighting devices from power fluctuations which may cause degradation or failure of the solid state lighting devices.

According to another aspect, a lighting system is provided comprising:
at least one luminaire according to any of the herein described embodiments, and
a controller configured to control the at least one luminaire.

The controller may be configured to control the intensity and/or the spectral composition of the light produced by the at least one luminaire. For a plurality of luminaires, the controller may be configured to provide a single control signal for controlling all of the luminaires, or alternatively may provide a control signal for controlling each individual luminaire.

According to yet another aspect, a paneled ceiling arrangement is provided which may comprise the at least one luminaire or the lighting system.

A paneled ceiling arrangement may comprise luminaires according to any of the herein described embodiments. For example, the luminaire(s) may be incorporated into the panel(s) of the paneled ceiling arrangement.

### BRIEF DESCRIPTION OF THE DRAWINGS

Embodiments of the invention are described in more detail and by way of non-limiting examples with reference to the accompanying drawings, wherein:
Fig. 1 shows an exploded perspective diagram of a prior-art up-down luminaire design.
Fig. 2 shows an exploded perspective diagram of a prior-art indirect luminaire design.
Fig. 3 shows an exploded perspective diagram of a prior-art indirect side-lit luminaire design.
Fig. 4 shows a cross-sectional view of a luminaire design according to an embodiment.
Fig. 5 shows a cross-sectional view of a luminaire design according to another embodiment.
Fig. 6 shows a cross-sectional view of a luminaire design according to yet another embodiment.
Fig. 7 shows a cross-sectional view of a luminaire design according to still another embodiment.
Fig. 8 shows an exploded perspective view of a luminaire design according to a further embodiment.

### DETAILED DESCRIPTION OF THE EMBODIMENTS

The invention will be described with reference to the Figures.

It should be understood that the detailed description and specific examples, while indicating exemplary embodiments of the apparatus, systems and methods, are intended for purposes of illustration only and are not intended to limit the scope of the invention. These and other features, aspects, and advantages of the apparatus, systems and methods of the present invention will become better understood from the following description, appended claims, and accompanying drawings. It should be understood that the Figures are merely schematic and are not drawn to scale. It should also be understood that the same reference numerals are used throughout the Figures to indicate the same or similar parts.

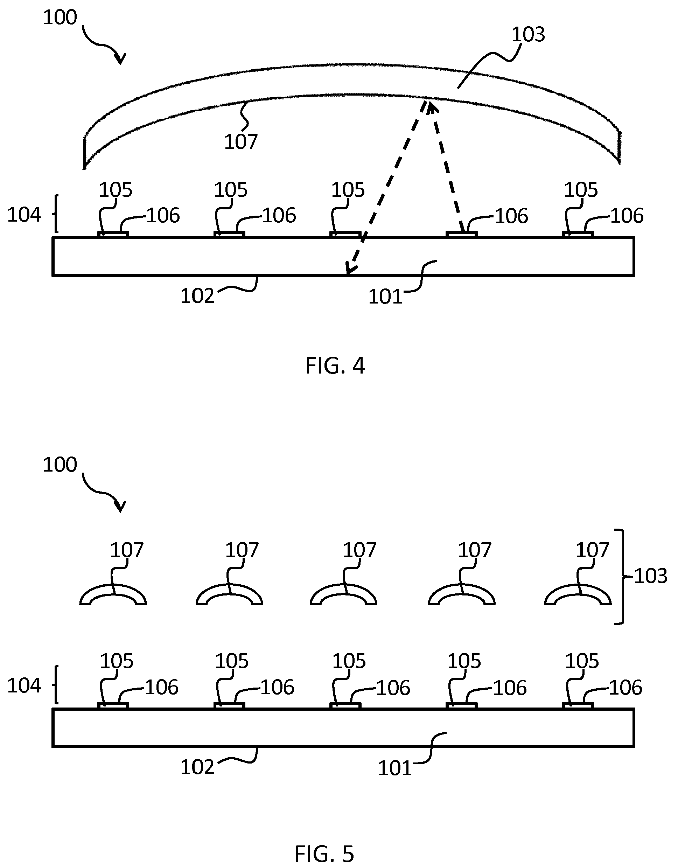

An embodiment of a luminaire 100 according to the present invention is depicted in the cross-sectional diagram in FIG. 4. In this embodiment, a light-transmissive carrier 101 carrying a pattern 104 of solid state lighting devices 105 is positioned opposite a reflector arrangement 103 comprising a reflective portion 107 which opposes the light-emissive surfaces 106 of the solid state lighting devices 105. The light-transmissive carrier 101 further comprises a light exit surface 102.

The light emanating from the emissive surfaces 106 of the solid state lighting devices 105 may be reflected/redirected by the reflector arrangement 103 towards the light exit surface 102 of the light emitting carrier 101. Accordingly, the reflected/redirect light may pass through the light-transmissive carrier 101 in order to reach the light exit surface 102.

Suitable materials for the light-transmissive carrier 101 may therefore include optically transmissive materials such as materials selected from a glass, a transmissive polymer or a transmissive polymer blend. In non-limiting examples, optical grade polymers such as polycarbonate, polyethylene terephthalate, poly(methyl methacrylate) and so on may be employed. Such materials may, as well as providing the requisite optical transmissive properties, be appropriately rigid and thus may be suitable materials on or in which to mount the solid state lighting devices 105. It is well-known that solid state lighting devices 105 may generate heat as well as light during use. The thermal properties (e.g. thermal conductivity) of such materials may assist in absorbance of the heat generated by the solid state lighting devices and transfer of this heat to the surroundings.

The light-transmissive carrier 101 may be transparent, translucent or diffuse. In an embodiment, the light-transmissive carrier 101 maybe at least partially diffusely transmissive such that the light-transmissive carrier 101 may act also as a diffuser. Diffusers may assist in glare-reduction and homogenizing of the light exiting the luminaire 100. Such a diffuser may be implemented in any suitable manner, e.g. by the light exit surface 102 being a roughened surface, the light exit surface 102 comprising scattering elements, and so on. This may assist in making the luminaire 100 or troffer according to the present invention more compact (i.e. slimmer) by virtue of incorporation of a diffuser into the light-transmissive carrier 101.

Alternatively or additionally, the light exit surface 102 may further comprise at least one optical element to shape the luminous distribution produced by the solid state lighting devices 105. For example, the light exit surface 102 may comprise one or more lenses, collimators or the like to shape the luminous distribution being directed to the light exit surface from the reflector arrangement 103. In a non-limiting example, the light exit surface 102 is a lens plate. The light exit surface 102 may be transparent, translucent or diffuse. For example, the light exit surface 102 may act as a diffuser of the luminous distribution being directed to the light exit surface 102 from the reflector arrangement 103.

It should be noted that the size of the solid state lighting devices 105 as shown in the Figures is greatly exaggerated for the sake of schematic clarity and that it is well-known that such devices (e.g. LEDs) may be extremely small in size such that they may occupy an area which is a very small fraction of the overall area of the light-transmissive carrier 101. Given that the solid state lighting devices 105 possess such small dimensions and are spatially separated in a pattern 104 on or in the light-transmissive carrier 101, the redirected light from the reflector arrangement 103 may illuminate the entirety of the light exit surface 102. This substantially full-window lighting effect may be achieved since the reflected light is not blocked from reaching the light exit surface by the solid state lighting devices 105 themselves nor any opaque carrier (which may otherwise be used to mount the solid state lighting devices). The 'masked' or shadow regions of the light exit surface 102 which may be directly beneath the solid state lighting devices 105 receive redirected light from the reflective portion 107 originating from the emissive surfaces 106 of neighbouring solid state lighting devices 105 in the pattern 104. This is shown by the dotted line in FIG. 4.

The pattern 104 of solid state lighting devices 105 may assist in illuminating such 'masked' regions of the light exit surface 102 since redirected light is supplied to the light exit surface 102 from several angles determined by the positions of the surrounding light-emissive surfaces 106 of neighbouring solid state lighting devices 105.

In a non-limiting example, the pattern 104 of solid state lighting devices 105 may not be perceived by an observer (not shown) beneath the light exit surface 102 of the luminaire 100 by virtue of the substantially full-window lighting effect as described above.

In an alternative non-limiting example, the shadow cast by the pattern 104 of solid state lighting devices 105 may be at least partially visible to an observer beneath the light exit surface 102 by virtue of the redirected light from the reflector arrangement 103 providing less illumination to particular defined 'masked' areas of the light exit surface. In such an example, the shadow cast by the partially visible pattern 104 may provide a decorative effect.

It should be understood that the number of rows of solid state lighting devices 105 of the pattern 104 is not especially limited. It will also be apparent to the skilled person that numerous other types of pattern 104 may be contemplated for implementing the present invention.

In an embodiment, the electrical connections between and/or to the solid state lighting devices 105 may be made via a (patterned) transmissive electrically conductive structure. Thus visible connections (e.g. visible wiring) may be at least partly obviated in order to enhance the substantially full-window lighting effect provided by the luminaire 100. For example, a transparent electrically conductive film may be employed as the transmissive electrically conductive structure. Such films (e.g. as indium tin oxide films, carbon nanotube (CNT) films, transparent nanowire-based conductors, metal meshes, conductive polymers etc.) are well-known per se and will not be elaborated upon herein for the sake of brevity only.

In an embodiment, the light-transmissive carrier 101 may comprise a glass printed circuit board upon which the solid state lighting devices 105 may be surface-mounted. Electrical connections may be provided to and/or between the solid state lighting devices 105 via printed conductive patterns which may be printed, for example, on the surface of the glass. Such printed patterns may be, for example, sufficiently thin and diffusely distributed such that they may not impinge on the substantially full-window lighting effect provided by the luminaire 100.

In a non-limiting example, the printed patterns on the glass printed circuit board may comprise the previously described transparent electrically conductive structure which may form transparent electrically conductive patterns on the glass printed circuit board. In this example, the substantially full-window lighting effect of the luminaire 100 may be assisted or enhanced by the optically transparent printed connections on the glass printed circuit board.

In a non-limiting example, the solid state lighting devices 105 may be directly mounted on or in the light-transmissive carrier 101 using a glue or adhesive strip. The glue/adhesive strip may, for example, be applied such that glue/adhesive strip does not extend beyond the interface between the solid state lighting device 105 and the light-transmissive carrier 101. Thus the means of adhering the solid state lighting devices 105 to the light-transmissive carrier 101 may not impinge on the substantially full-window lighting effect provided by the luminaire 100. In an example, the glue/adhesive strip may be thermally conducting such that dissipation of the heat generated by the solid state lighting devices 105 to the light-transmissive carrier 101 may be assisted.

In an embodiment, the solid state lighting devices 105 may be driven by a driver circuit (not shown) which is configured to regulate the power supplied to them. Driver circuits for solid state lighting devices are well-known per se and will not be further described herein for the sake of brevity only. The driver circuit may be located inside the luminaire 100 or alternatively may be positioned separately from the luminaire 100. In a non-limiting example, the driver circuit may be directly mounted on or embedded within the light-transmissive carrier 101. For example, in order to assist heat dissipation, the driver circuit may be mounted on the light-transmissive carrier using a thermally conductive glue/adhesive strip(s). In this example, some shielding (not shown) may optionally be used to obscure the driver circuit from view. The shielding may be made of any suitable material. In a non-limiting example, the shielding may be a printed black matrix.

The solid state lighting devices 105 preferably may be LEDs. In an embodiment, at least two of the solid state lighting devices 105 are adapted to emit light of different colour with respect to each other. In an example, the at least two solid state lighting devices may be dimmable and/or may be able to produce an output having a configurable spectral composition, e.g. a white light output having a configurable colour temperature, e.g. a colour temperature ranging from about 2,000 to about 8,000 K, e.g. from about 2,500 K to about 6,500 K, and/or a configurable coloured output having a spectral composition having a central spectral component ranging from 400 nm to 700 nm for example. The luminaire 100 may achieve a configurable luminous output in any suitable manner: for example, by each individual solid state lighting device 105 being able to produce such a configurable luminous output or by a plurality of individually controllable solid state lighting devices 105 producing outputs of different spectral compositions, wherein a selection of solid state lighting devices 105 may be engaged to produce an output of a desired spectral composition.

In a non-limiting example, the spectral composition provided by the luminaire 100 comprising different colour-emitting solid state lighting devices 105 may be homogenized by employing a reflector arrangement 103 comprising reflective portion(s) 107 which is/are at least partially diffusively reflective. Alternatively or additionally, a partially diffusive light-transmissive carrier 101 may be employed to assist in colour-mixing of the light emitted by the solid state lighting devices 105.

The reflective portions 107 may, in non-limiting examples, comprise reflective materials such as metal, glass and the like. Alternatively or additionally, the reflective portions 107 may comprise a non-reflective material (e.g. a polymer, wood, fibreboard etc.) carrying a reflective material, such as in the form of a reflective coating. Such a reflective coating is not especially limited and may comprise a glass, metal, mineral, and the like. Inclusion of a mineral, such as TiO₂, into the reflective coating may assist in the reflective portion 107 providing diffuse reflectance. Reflective materials/coatings are well-known per se and will not be further described herein for the sake of brevity only.

FIG. 5 depicts a cross-section view of another embodiment of the present invention, wherein a luminaire 100 may comprise a reflector arrangement 103 comprising a plurality of reflective portions 107. The pattern 104 of spatially separated solid state lighting devices 105 may comprise groups of solid state lighting devices which may each be aligned with respect to a reflective portion 107 of the reflector arrangement 103. Accordingly, the light emitted by each group may be substantially reflected by the opposing reflective portion 107 aligned with said group.

In an embodiment, the pattern 104 comprises at least one row of solid state lighting devices 105. In a non-limiting example, each row may be considered a group of solid state lighting devices 105 and thus each row may be aligned with respect to an opposing reflective portion 107. The light emitted from solid state lighting devices 105 belonging to a particular row may illuminate 'masked' areas beneath solid state lighting devices 105 belonging to the same row via reflection from an aligned reflective portion 107 and thus the substantially full-window lighting effect may be attained. Alternatively or additionally, the light emitted from solid state lighting devices 105 belonging to a particular row may illuminate 'masked' areas beneath solid state lighting devices 105 belonging to different rows in order to attain the substantially full-window lighting effect.

In a non-limiting example depicted in FIG. 5, the reflective portions 107 are arcuate and the reflector arrangement 103 is positioned such that each of the arcuate reflective portions 107 opposes a row of solid state lighting devices 105. Indirect and substantially full-window effect lighting is provided by reflection of the light emitted by the pattern 104 of solid state lighting devices 105 by the arcuate reflection portions 107 towards the light exit surface 102; the redirected light passing through the light-transmissive carrier 101. It should be understood that an arcuate shape for the reflective portions 107 is an example only, and that any suitable shape for the reflective portions 107 may be used.

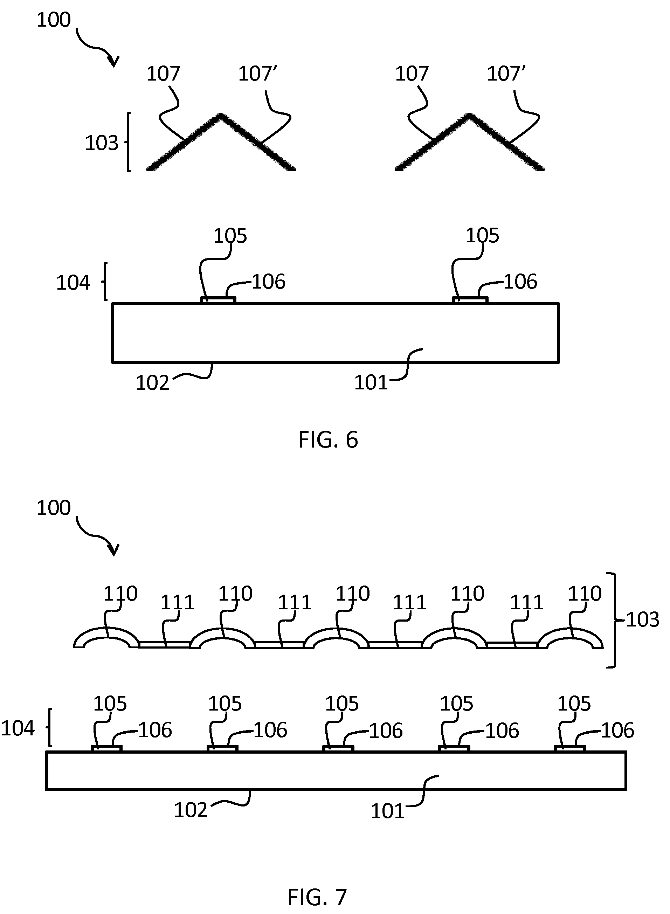

FIG. 6 depicts a cross-section view of still another embodiment, wherein a luminaire 100 may comprise two rows of solid state lighting devices 105 wherein each row is facing a pair of angled, partially mutually opposing reflective portions 107, 107' of the reflector arrangement 103. Indirect and substantially full-window effect lighting is provided by reflection of the light emitted by the pattern 104 of solid state lighting devices 105 by the angled, partially mutually opposing reflective portions 107, 107' towards the light exit surface 102; the redirected light passing through the light-transmissive carrier 101.

Yet another alternative example embodiment is shown in FIG. 7 which depicts the cross-section of a luminaire 100 wherein the reflector arrangement 103 is a corrugated reflector comprising a plurality of reflective troughs 110 which each oppose the rows of solid state lighting devices 105 of the pattern 104. In an example, the reflective troughs 110 are coupled by ridges 111 which optionally may be also reflective. Indirect and substantially full-window effect lighting is provided by reflection of the light emitted by the pattern 104 of solid state lighting devices 105 by the reflective troughs 110, and optionally by the ridges 111, towards the light exit surface 102; the redirected light passing through the light-transmissive carrier 101.

Other suitable reflector arrangements 103 of the luminaire 100 will be immediately apparent to the skilled person.

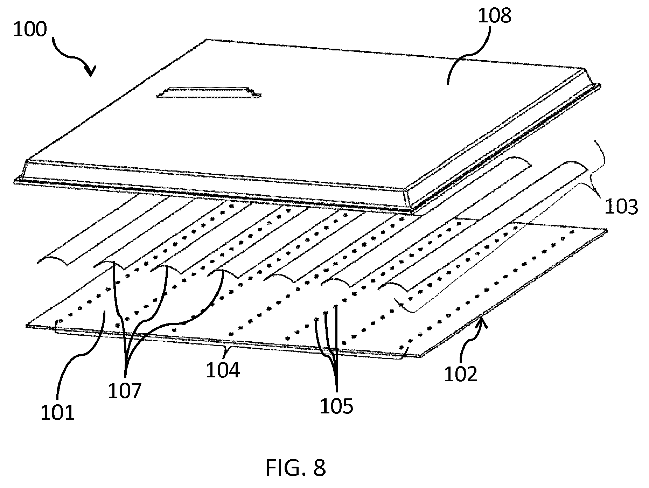

FIG. 8 depicts an exploded perspective view of a further embodiment of the luminaire 100, wherein the luminaire 100 is partially encompassed by a housing 108. The luminaire 100 as depicted in FIG. 8 may comprise a rectangular light exit surface 102. Each row of solid state lighting devices 105 of the pattern 104 mounted on the light-transmissive carrier 101 may oppose a reflective portion 107 of the reflector arrangement 103 as previously described.

The housing 108 may assist in mounting and alignment of the light-transmissive carrier 101 and reflector arrangement 103, as well as protecting the components of the luminaire from damage and contamination (e.g. by dust). The light-transmissive carrier 101 and reflector arrangement 103 may be attached to the housing 108 in any suitable manner, e.g. using screws mating with threaded holes in the housing 108.

In a non-limiting example, the driver circuit for regulating power to the solid state lighting devices 105 is located in the luminaire 100, for example inside the housing 108. The driver circuit may, for example, be positioned between the reflector arrangement 103 and the housing 108 such that its presence may not detract from the substantially full-window effect delivered by the luminaire 100. The driver circuit may be attached to the housing 108 by any suitable means such as by gluing, using screws mating with threaded holes in the housing 108, and the like.

In an alternative example embodiment, the luminaire 100 may not comprise a housing such that the exposed design features of the luminaire (e.g. the light-transmissive carrier 101, solid state lighting devices 105 and reflector arrangement 103) may be more easily viewed. In such an embodiment, the reflector arrangement 103 may, for example, be mechanically coupled to the light-transmissive carrier 101. Such coupling may be achieved by rigid attachments (e.g. rods) or flexible attachments (e.g. cables/wires) connecting the reflector arrangement 103 to the light transmissive carrier 101. Such attachments may, for example, be positioned at the extremities of the luminaire 100 in order not to impinge on the substantially full-window lighting effect provided by the luminaire 100.

The luminaire 100 shown in the various embodiments above may be a troffer which may be employed as a panel in a paneled ceiling arrangement. In a non-limiting example, the luminaire 100 may be recessed into the plenum area (not shown) above the paneled ceiling arrangement (not shown).

An advantage of the luminaire 100 according to the present invention is that it may be more compact (e.g. slimmer) than alternative indirect full-window effect luminaire designs (e.g. the side lit luminaire 30 shown in FIG. 3) owing to the incorporation of the solid state lighting devices 105 on or in the light-transmissive carrier. This may provide the advantage that the luminaire 100 may require less construction material and thus may be fabricated at lower cost. Additionally, given that troffers are often recessed into a paneled ceiling arrangement, a slimmer design may be advantageous since the ceiling-facing side of the troffer may extend less intrusively into the plenum space above the ceiling which may allow greater flexibility in terms of the use of space both below and above the paneled ceiling. For example, the more compact luminaire 100 according to the present invention may allow for higher positioning of a paneled ceiling arrangement such that the height of a living/working space may be increased.

In alternative non-limiting examples, the compact design of the luminaire 100 according to the present invention may be suspended from a ceiling (rather than being recessed into a ceiling). The luminaire 100 may alternatively or additionally be employed as a wall or floor lighting fixture.

The compact design of the luminaire 100 may offer further advantages in terms of flexibility to include more elaborate (and effective) reflector arrangements 103 which may otherwise be overlooked due to their use potentially resulting in a disadvantageously/unacceptable thick luminaire.

In an embodiment of the present invention, there is provided a lighting system comprising at least one luminaire of the present invention and a controller to control the at least one luminaire. In a non-limiting example, the controller may be configured to provide a control signal for controlling each individual luminaire or alternatively may be configured to provide a single control signal for controlling several luminaires. The controller may, for example, be operated by a user and/or may provide automatic control over the luminaire(s). Such automatic control may, for example, be based on a preset lighting routine or sensory input. For example, the controller may be adapted to adjust at least one of a dimming level and the spectral composition of the luminous output of the luminaire 100, in response to a sensor signal. Alternatively or additionally, the controller may increase or decrease the number of solid state lighting devices 105 being switched on in response to such a sensor signal. Other suitable sensor-controlled adjustments to the luminous output of the luminaire 100 will be immediately apparent to the skilled person.

In an an embodiment of the present invention, any of the above described embodiments of the luminaire 100 and/or the lighting system may be incorporated in a paneled ceiling arrangement. Such an arrangement typically comprises a plurality of panels that can be suspended from a ceiling in a frame mounted to the ceiling, which frame may be a modular frame, e.g. formed from a plurality of interconnected frame elements, e.g. strips. In such a paneled ceiling arrangement, the luminaires 100 may form or replace at least some of the panels of the paneled ceiling arrangement in order to provide ceiling lighting. In such a paneled ceiling arrangement, luminaires 100 in the form of troffers are particularly preferred.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A luminaire (100) comprising:
a light-transmissive carrier (101) comprising a light exit surface (102);
a reflector arrangement (103) opposite the light-transmissive carrier for redirecting light towards the light exit surface; and
a pattern (104) of spatially separated solid state lighting devices (105) directly mounted on or in the light-transmissive carrier, each of the solid state lighting devices comprising a light-emissive surface (106) facing the reflector arrangement.

2. The luminaire (100) of claim 1, wherein the luminaire is a troffer and the light exit surface (102) is rectangular or circular.

3. The luminaire (100) of claim 1 or 2, wherein the light-transmissive carrier (101) comprises a transmissive material selected from a glass, a transmissive polymer or a transmissive polymer blend.

4. The luminaire (100) of any of claims 1-3, wherein the light-transmissive carrier (101) comprises a transmissive electrically conductive structure such as a transparent electrically conductive film, wherein the solid state lighting devices are conductively coupled to the transmissive electrically conductive structure.

5. The luminaire (100) of any of claims 1-4, wherein the light-transmissive carrier (101) comprises a glass printed circuit board, wherein the solid state lighting devices (105) are surface-mounted on the glass printed circuit board.

6. The luminaire (100) of any of claims 1-5, wherein the light-transmissive carrier (101) is at least partially diffusively transmissive.

7. The luminaire (100) of any of claims 1-6, wherein:
the pattern (104) of spatially separated solid state lighting devices (105) comprises groups of solid state lighting devices;
the reflector arrangement (103) comprises a plurality of reflective portions (107), each reflective portion aligning with one of said groups.

8. The luminaire (100) of any of claims 1-7, wherein the pattern (104) comprises at least one row of solid state lighting devices (105).

9. The luminaire (100) of any of claims 1-8, wherein at least two of the solid state lighting devices (105) are adapted to emit light of different colour with respect to each other.

10. The luminaire (100) of claim 9, wherein the at least two of the solid state lighting devices (105) are individually controllable.

11. The luminaire (100) of any of claims 1-10, wherein the reflector arrangement (103) comprises reflective portions (107) which are specularly and/or diffusively reflective.

12. A luminaire (100) of any of claims 1-11, wherein the luminaire is at least partially encompassed by a housing (108).

13. A luminaire (100) of any of claims 1-12, wherein the luminaire comprises a driver circuit configured to regulate power supplied to the solid state lighting devices (105).

14. A lighting system comprising:
at least one luminaire (100) of any of claims 1-13; and
a controller configured to control the at least one luminaire.

15. A paneled ceiling arrangement comprising at least one luminaire (100) according to any of claims 1-13 or a lighting system according to claim 14.
